(19) Europäisches Patentamt
European Patent Office
Office européen des brevets

(11) Veröffentlichungsnummer: **0 026 821**
**B1**

(12) **EUROPÄISCHE PATENTSCHRIFT**

(45) Veröffentlichungstag der Patentschrift: **06.04.83**

(51) Int. Cl.³: **G 03 C 1/70,** G 03 F 7/10, C 08 L 79/04

(21) Anmeldenummer: **80104644.2**

(22) Anmeldetag: **06.08.80**

(54) **Verfahren zur Herstellung hochwärmebeständiger Reliefstrukturen, danach hergestellte Reliefstrukturen und deren Verwendung.**

(30) Priorität: **21.08.79 DE 2933805**

(43) Veröffentlichungstag der Anmeldung: **15.04.81 Patentblatt 81/15**

(45) Bekanntmachung des Hinweises auf die Patenterteilung: **06.04.83 Patentblatt 83/14**

(84) Benannte Vertragsstaaten: **AT BE CH DE FR GB IT LI NL SE**

(56) Entgegenhaltungen:
**DE-A-2 105 616**
**DE-A-2 727 253**
**DE-A-2 839 751**
**DE-B-2 115 373**
**FR-A-2 350 625**
**US-A-3 794 494**

(73) Patentinhaber: **SIEMENS AKTIENGESELLSCHAFT, Berlin und München Wittelsbacherplatz 2, D-8000 München 2 (DE)**

(72) Erfinder: **Ahne, Hellmut, Dr., Heidestrasse 6, D-8551 Röttenbach (DE)**
Erfinder: **Kühn, Eberhard, Bergstrasse 32, D-8551 Hemhofen (DE)**
Erfinder: **Rubner, Roland, Dr., Buchenring 15, D-8551 Röttenbach (DE)**
Erfinder: **Schmidt, Erwin, Elise-Späth-Strasse 23, D-8520 Erlangen (DE)**

**EP 0 026 821 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

# Verfahren zur Herstellung hochwärmebeständiger Reliefstrukturen, danach hergestellte Reliefstrukturen und deren Verwendung

Die Erfindung betrifft ein Verfahren zur Herstellung hochwärmebeständiger Reliefstrukturen durch Auftragen strahlungsempfindlicher löslicher Polymer-Vorstufen in Form einer Schicht oder Folie auf ein Substrat, Bestrahlen der Schicht bzw. Folie durch Negativvorlagen mit aktinischem Licht oder durch Führen eines Licht-, Elektronen- oder Ionenstrahls, Entfernen der nichtbestrahlten Schicht- bzw. Folienteile und gegebenenfalls durch nachfolgendes Tempern, sowie die Verwendung derart hergestellter Reliefstrukturen.

Ein Verfahren der genannten Art zur Herstellung von Reliefstrukturen auf der Basis von Polymeren ist aus der deutschen Patentschrift 2 308 830 bzw. der entsprechenden US-Patentschrift 3 957 512 bekannt. Bei diesem Verfahren werden als lösliche Polymer-Vorstufen Polyadditions- oder Polykondensationsprodukte polyfunktioneller carbocyclischer oder heterocyclischer, strahlungsempfindliche Reste tragender Verbindungen mit Diaminen, Diisocyanaten, Bis-säurechloriden oder Dicarbonsäuren verwendet. Die Verbindungen, die strahlungsempfindliche Reste tragen, enthalten dabei zwei für Additions- oder Kondensationsreaktionen geeignete Carboxyl-, Carbonsäurechlorid-, Amino-, Isocyanat- oder Hydroxylgruppen und teilweise in ortho- oder peri-Stellung dazu esterartig an Carboxylgruppen gebundene strahlungsreaktive Gruppen. Die mit diesen Verbindungen umzusetzenden Diamine, Diisocyanate, Bis-säurechloride und Dicarbonsäuren weisen mindestens ein cyclisches Strukturelement auf.

Die löslichen Polymer-Vorstufen werden beim Bestrahlen vernetzt und gehen dabei in unlösliche Zwischenprodukte über. Diese Zwischenprodukte unterliegen bei der Temperung einer Cyclisierung, wobei hochwärmebeständige Polymere folgender Stoffklassen gebildet werden: Polyimide, Polyamidimide, Polyesterimide, Poly-1.3-chinazolin-2.6-dione, Polyisoindolochinazolindione, Poly-1.3-oxazin-6-one und Polybenz-1.3-oxazin-2.4-dione.

Aufgabe der Erfindung ist es, das Verfahren der eingangs genannten Art in der Weise weiter auszugestalten, dass das Angebot an hochwärmebeständigen Reliefstrukturen verbreitert wird.

Dies wird erfindungsgemäss dadurch erreicht, dass Vorstufen von Polyoxazolen in Form von Additionsprodukten olefinisch ungesättigter Monoepoxide an hydroxylgruppenhaltige Polykondensationsprodukte von aromatischen und/oder heterocyclischen Dihydroxydiaminoverbindungen mit Dicarbonsäurechloriden oder -estern verwendet werden.

Reliefstrukturen auf der Basis von Polyoxazolen sind bislang noch nicht bekannt. Die nach dem erfindungsgemässen Verfahren hergestellten Reliefstrukturen, die auf dieser Basis beruhen, weisen eine ausgezeichnete Temperaturbeständigkeit auf und zwar sowohl unter Stickstoff als auch an der Luft. Eine hohe thermische Belastbarkeit wird aber heutzutage bei modernen Strukturierungstechniken, wie Trockenätzverfahren, und bei der Ionenimplantation gefordert. Die nach dem erfindungsgemässen Verfahren hergestellten Polyoxazol-Reliefstrukturen sind darüber hinaus ausgezeichnet hydrolysebeständig und weisen eine hohe Resistenz gegen alkalische Ätzbäder auf, was insbesondere bei Nassätzprozessen von Bedeutung ist.

Beim erfindungsgemässen Verfahren können die Polymer-Vorstufen vorteilhaft zusammen mit licht- oder strahlungsempfindlichen copolymerisationsfähigen Verbindungen eingesetzt werden. Dazu werden vorzugsweise N-substituierte Maleinimide verwendet. Es können aber auch acrylat- bzw. methacrylatgruppenhaltige Verbindungen eingesetzt werden. Weiter können auch übliche Photoinitiatoren und/oder -sensibilisatoren verwendet werden (vgl.: «Industrie Chimique Belge», 24, 1959, S. 739 bis 764, sowie J. Kosar, «Light-Sensitive Systems», John Wiley & Sons Inc., New York 1965, S. 143 bis 146 und S. 160 bis 188). Besonders geeignet sind Michlers Keton und/oder Benzoinäther, 2-tert.Butyl-9.10-anthrachinon, 1.2-Benz-9.10-anthrachinon und 4.4'-Bis-(diäthylamino)-benzophenon. Ferner können beim erfindungsgemässen Verfahren vorteilhaft Haftvermittler verwendet werden. Dazu dienen insbesondere Silane, wie Vinyltriäthoxysilan, Vinyl-tris(β-methoxy-äthoxy)-silan, γ-Methacryloxypropyl-trimethoxysilan und γ-Glycidoxy-propyltrimethoxysilan.

Die beim erfindungsgemässen Verfahren eingesetzten strahlungsreaktiven Polyoxazol-Vorstufen, die oligomerer und/oder polymerer Natur sind, sind in der gleichzeitig eingereichten europäischen Patentanmeldung «Polyoxazol-Vorstufen sowie deren Herstellung», Nr. 25 506, beschrieben. Diese Vorstufen weisen im allgemeinen folgende Struktur auf:

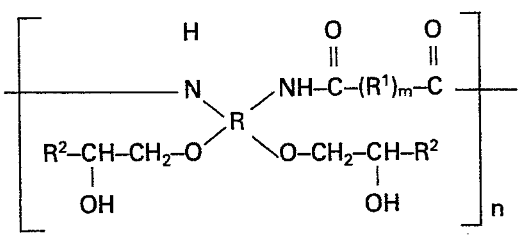

(1)

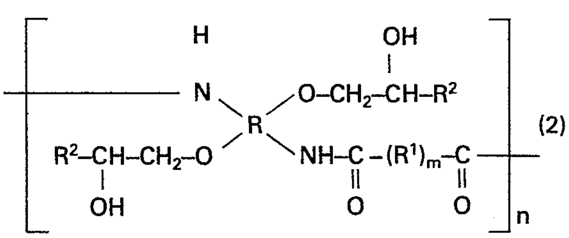

(2)

In den Formeln (1) und (2) bedeutet n eine ganze Zahl von 2 bis etwa 100 und m ist 0 oder 1.

Für R, $R^1$ und $R^2$ gilt folgendes:

R ist ein – gegebenenfalls halogenierter – zumindest partiell aromatischer und/oder heterocyclischer tetravalenter, d.h. tetrafunktioneller Rest, bei dem jeweils zwei Valenzen in Nachbarstellung zueinander angeordnet sind; weist der Rest R mehrere aromatische und/oder heterocyclische Strukturelemente auf, so befinden sich die Valenzpaare jeweils an endständigen derartigen Strukturelementen;

$R^1$ ist ein – gegebenenfalls halogenierter – divalenter, d.h. difunktioneller Rest aliphatischer und/oder cycloaliphatischer, gegebenenfalls Heteroatome aufweisender, und/oder aromatischer und/oder heterocyclischer Struktur;

$R^2$ ist ein olefinisch ungesättigter Rest, beispielsweise eine allylätherhaltige Gruppe, insbesondere eine – gegebenenfalls substituierte – (meth)acrylesterhaltige Gruppe.

Bevorzugt sind dabei Additionsprodukte von Glycidylacrylat oder -methacrylat an das Polykondensationsprodukt aus 3.3'-Dihydroxybenzidin und Isophthalsäuredichlorid oder Benzophenondicarbonsäuredichlorid. Ein Beispiel für eine derartige Polymer-Vorstufe ist in der nachfolgenden Formel (3) dargestellt:

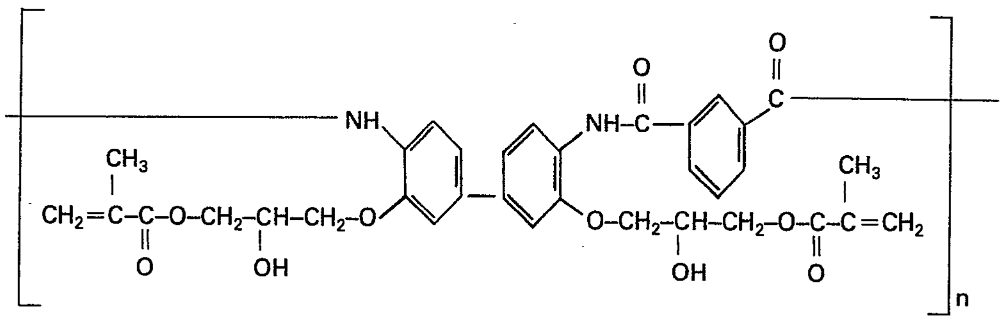

3

Die Herstellung der erfindungsgemässen Reliefstrukturen erfolgt, wie bereits ausgeführt, in der Weise, dass die Polymer-Vorstufe in Form einer Schicht oder Folie auf ein Substrat aufgebracht und mit aktinischem Licht durch eine Maske belichtet oder durch Führen eines Licht-, Elektronen- oder Ionenstrahls bestrahlt wird; anschliessend werden die nichtbelichteten bzw. nichtbestrahlten Schicht- oder Folienteile herausgelöst oder abgezogen und die dabei erhaltenen Reliefstrukturen werden gegebenenfalls getempert. Die Vorstufe kann vorteilhaft in einem organischen Lösungsmittel gelöst auf das Substrat aufgebracht werden; vorzugsweise wird als Lösungsmittel N-Methylpyrrolidon verwendet. Die Konzentration der Lösung kann so eingestellt werden, dass mit bekannten Beschichtungsverfahren, wie Schleudern, Tauchen, Sprühen, Bürsten oder Rollen, Schichtstärken von 0,01 µm bis einige 100 µm erzeugt werden können.

Es hat sich gezeigt, dass beispielsweise beim Schleuderbeschichten 300 bis 10 000 Umdrehungen pro Minute für die Dauer von 1 bis 100 Sekunden geeignet sind, um eine gleichmässige und gute Oberflächenqualität zu erzielen. Die auf das Substrat, das vorzugsweise aus Glas, Metall, Kunststoff oder halbleitendem Material besteht, aufgebrachte Photoresistschicht kann bei Raumtemperatur oder bei erhöhter Temperatur, vorzugsweise bei einer Temperatur von 50 bis 80 °C, in einem Stickstoff- oder Luftstrom vom Lösungsmittel befreit werden; dabei kann auch im Vakuum gearbeitet werden.

Zur Erzielung eines ausreichenden Löslichkeitsunterschiedes zwischen den bestrahlten und den nichtbestrahlten Schicht- bzw. Folienteilen genügen beim erfindungsgemässen Verfahren – bei der Verwendung einer 500 W-Quecksilberhöchstdrucklampe – in Abhängigkeit von der Zusammensetzung und der Schichtstärke Belichtungszeiten zwischen 20 und 800 Sekunden. Nach dem Belichten werden die nichtbelichteten Teile der Schicht bzw. Folie herausgelöst, vorzugsweise mit einem organischen Entwickler.

Mittels des erfindungsgemässen Verfahrens werden konturenscharfe Bilder, d.h. Reliefstrukturen, erhalten, die durch Temperung in hochwärmebeständige, gegenüber Säuren und Laugen resistente Polymere umgewandelt werden. Im allgemeinen können Temperaturen von 220 bis 500 °C gewählt werden, vorzugsweise wird bei Temperaturen von 300 bis 400 °C getempert. Die Temperzeit beträgt im allgemeinen eine halbe Stunde, wobei weder unter Stickstoff noch an der Luft eine Verfärbung zu beobachten ist. Die Kantenschärfe und die Massgenauigkeit der Reliefstrukturen werden durch die Temperung praktisch nicht beeinträchtigt. Darüber hinaus bleibt die gute Oberflächenqualität der Reliefstrukturen trotz eines beim Tempern eintretenden Schichtstärkenverlustes erhalten.

Beim erfindungsgemässen Verfahren werden vorzugsweise Polymer-Vorstufen aus aromatischen Komponenten eingesetzt, so dass bei der thermischen Behandlung, d.h. bei der Temperung, Polymere – in Form von Polyoxazolen – mit folgender Struktureinheit (4) gebildet werden:

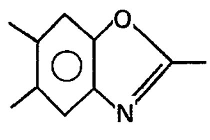

(4)

Polyoxazole gehören zu den Halb-Leiterpolymeren und zeichnen sich durch eine hohe Temperaturbeständigkeit aus (bis zu ca. 520 °C).

Die erfindungsgemässen Reliefstrukturen können zur Herstellung von Passivierungsschichten auf Halbleiterbauelementen, von Dünn- und Dickfilmschaltungen, von Lötschutzschichten auf Mehrlagenschaltungen, von Isolierschichten als Bestandteil von Schichtschaltungen und von miniaturisierten Isolierschichten auf elektrisch leitenden und/oder halbleitenden und/oder isolierenden Basismaterialien, insbesondere im Bereich der Mikroelektronik oder allgemein für die Feinstrukturierung von Substraten, Anwendung finden. Vorzugsweise dienen die hochwärmebeständigen Reliefstrukturen als Masken für Nass- und Trockenätzprozesse, stromlose oder galvanische Metallabscheidung und Aufdampfverfahren sowie als Masken für die Ionenimplantation, darüber hinaus als Isolier- und Schutzschichten in der Elektrotechnik. Ferner können die Reliefstrukturen vorteilhaft als Orientierungsschichten, beispielsweise in Flüssigkristalldisplays, sowie zur Rasterung von Oberflächen, beispielsweise bei Röntgenschirmen, insbesondere Röntgenbildverstärkern, verwendet werden.

Anhand von Ausführungsbeispielen soll die Erfindung noch näher erläutert werden.

1. Herstellung einer strahlungsreaktiven Polybenzoxazol-Vorstufe

Zu einer Lösung von 6,49 Gewichtsteilen 3.3'-Dihydroxybenzidin in 50 Volumenteilen Dimethylacetamid und 9 Volumenteilen Pyridin werden unter intensivem Rühren bei einer Temperatur von $-5$ bis $-20$ °C innerhalb von etwa 30 Minuten 6,1 Gewichtsteile Isophthalsäuredichlorid in 20 Volumenteilen Cyclohexanon getropft. Nach 3stündigem weiteren Rühren bei Raumtemperatur wird die viskose Reaktionslösung über Nacht stehengelassen, dann wird die Lösung unter Rühren in 1000 Volumenteile Wasser getropft. Das sich dabei abscheidende Harz wird abgetrennt, mit Wasser und Methanol gewaschen und im Vakuum bei ca. 60 °C getrocknet.

10 Gewichtsteile des auf die beschriebene Weise hergestellten Polybenzoxazol-Prepolymeren werden in 100 Volumenteilen N-Methylpyrrolidon gelöst. Zu dieser Lösung werden 50 Volumenteile Glycidylmethacrylat, 0,5 Volumenteile Benzyldimethylamin und 0,5 Gewichtsteile Hydrochinon gegeben. Nach 2stündigem Erwärmen auf eine Temperatur von ca. 90 °C wird das Reaktionsprodukt unter Rühren aus 1000 Volumenteilen Äthanol gefällt. Nach dem Trocknen im Vakuum wird ein gelbbraunes Pulver erhalten.

2. Herstellung einer Reliefstruktur

5 Gewichtsteile der auf die vorstehend beschriebene Weise hergestellten Polybenzoxazol-Vorstufe werden zusammen mit 0,25 Gewichtsteilen N-Phenylmaleinimid, 0,1 Gewichtsteilen Michlers Vinyl-tris(β-ethoxy-äthoxy)-silan in 20 Volumenteilen eines Gemisches aus Dimethylacetamid und Dioxan (Volumenverhältnis 1:1) gelöst. Die Lösung wird bei 1000 Umdrehungen pro Minute auf einem Siliciumwafer mit einer Siliciumdioxid-Oberfläche zu Filmen geschleudert. Anschliessend wird bei ca. 65 °C 3 Stunden im Vakuum getrocknet und danach mit einer 500 W-Quecksilberhöchstdrucklampe 6 Minuten lang durch eine Kontakttestmaske belichtet. Dann wird 45 Sekunden lang mit einem Lösungsmittelgemisch aus Methyläthylketon, N-Methylpyrrolidon, γ-Butyrolacton und Toluol (Volumenverhältnis 1:1:1:1) entwickelt. Dabei wird eine Reliefstruktur mit einer Schichtstärke von 4 µm und einem Auflösungsvermögen von 7 µm erhalten. Die nachfolgende Temperung bei 275 °C und 400 °C, jeweils für eine halbe Stunde, führt – ohne Beeinträchtigung der Strukturqualität – zu einer Schichtstärke von 2,1 µm.

**Patentansprüche**

1. Verfahren zur Herstellung hochwärmebeständiger Reliefstrukturen durch Auftragen strahlungsempfindlicher löslicher Polymer-Vorstufen in Form einer Schicht oder Folie auf ein Substrat, Bestrahlen der Schicht bzw. Folie durch Negativvorlagen mit aktinischem Licht oder durch Führen eines Licht-, Elektronen- oder Ionenstrahls, Entfernen der nichtbestrahlten Schicht- bzw. Folienteile und gegebenenfalls durch nachfolgendes Tempern, dadurch gekennzeichnet, dass Vorstufen von Polyoxazolen in Form von Additionsprodukten olefinisch ungesättigter Monoepoxide an hydroxylgruppenhaltige Polykondensationsprodukte von aromatischen und/oder heterocyclischen Dihydroxydiaminoverbindungen mit Dicarbonsäurechloriden oder -estern verwendet werden.

2. Verfahren nach Anspruch 1, dadurch gekennzeichnet, dass die Polymer-Vorstufen zusammen mit licht- oder strahlungsempfindlichen copolymerisationsfähigen Verbindungen eingesetzt werden.

3. Verfahren nach Anspruch 2, dadurch gekennzeichnet, dass N-substituierte Maleinimide verwendet werden.

4. Verfahren nach einem der Ansprüche 1 bis 3, dadurch gekennzeichnet, dass Haftvermittler, insbesondere Silane, verwendet werden.

5. Verfahren nach einem oder mehreren der Ansprüche 1 bis 4, dadurch gekennzeichnet, dass ein Additionsprodukt von Glycidylacrylat oder -methacrylat an das Polykondensationsprodukt aus 3.3'-Dihydroxybenzidin und Isophthalsäuredichlorid oder Benzophenondicarbonsäuredichlorid verwendet wird.

6. Hochwärmebeständige Reliefstruktur, hergestellt nach einem oder mehreren der Ansprüche 1 bis 5.

7. Verwendung der Reliefstruktur nach Anspruch 6 als Resist mit intermediärer Schutzfunktion zur lithographischen Strukturierung von Oberflächen, insbesondere bei Trockenätzverfahren.

8. Verwendung der Reliefstruktur nach Anspruch 6 zur dauerhaften Beschichtung oder Rasterung von Oberflächen.

9. Verwendung der Reliefstruktur nach Anspruch 6 als Schutz- und Isolierstoff in der Elektrotechnik.

**Revendications**

1. Procédé de fabrication de structures en relief stables à haute température en appliquant sur un substrat des précurseurs de polymères solubles sensibles à un rayonnement sous la forme d'une

couche ou d'une feuille, en exposant la couche ou feuille à de la lumière actinique à travers des modèles négatifs, ou en envoyant un faisceau lumineux, d'électrons ou d'ions, en éliminant les parties de couche ou feuille non exposées et éventuellement en soumettant à un recuit ultérieur, caractérisé en ce qu'il consiste à utiliser des précurseurs de polyoxazoles sous forme de produits d'addition de monoépoxydes insaturés oléfiniquement sur des produits de polycondensation, contenant des groupes hydroxy, de composés dihydroxydiamino aromatiques et/ou hétérocycliques et de chlorures ou d'esters d'acides dicarboxyliques.

2. Procédé suivant la revendication 1, caractérisé en ce qu'il consiste à utiliser les précurseurs de polymère en même temps que des composés aptes à copolymériser sensibles à la lumière ou à un rayonnement.

3. Procédé suivant la revendication 2, caractérisé en ce qu'il consiste à utiliser des maléinimides substitués sur l'azote.

4. Procédé suivant l'une des revendications 1 à 3, caractérisé en ce qu'il consiste à utiliser des agents de pontage, notamment des silanes.

5. Procédé suivant l'une ou plusieurs des revendications 1 à 4, caractérisé en ce qu'il consiste à utiliser un produit d'addition d'acrylate de glycidyle ou de méthacrylate de glycidyle sur le produit de polycondensation constitué de 3,3'-dihydroxybenzidine et de dichlorure d'acide isophtalique ou de dichlorure d'acide benzophénonedicarboxylique.

6. Structure en relief stable à haute température fabriquée par le procédé suivant l'une des revendications 1 à 5.

7. Utilisation de la structure en relief suivant la revendication 6 comme agent photorésistant ayant une fonction intermédiaire de protection pour la structuration par voie lithographique de surfaces, notamment dans un procédé d'attaque à sec.

8. Utilisation de la structure en relief suivant la revendication 6 pour le revêtement ou le quadrillage permanents de surfaces.

9. Utilisation de la structure en relief suivant la revendication 6 comme matière de protection et isolante dans l'électrotechnique.

**Claims**

1. A process for the production of highly heat-resistant relief structures by the application of radiation-sensitive, soluble polymer precursors in the form of a layer or film to a substrate, irradiation of the layer or foil through negative masks using actinic actinic light or by the guiding of a light beam, electron beam or ion beam, removal of the non-irradiated parts of the layer or film, and possibly subsequent annealing, characterised in that polyoxazole precursors are used in the form of addition products of olefinically-unsaturated mono-epoxides with polycondensation products, containing hydroxyl groups, of aromatic and/or heterocyclic dihydroxydiamino-compounds with dicarboxylic acid chlorides or esters.

2. A process as claimed in Claim 1, characterised in that the polymer precursors are used together with light-sensitive or radiation-sensitive copolymerisable compounds.

3. A process as claimed in Claim 2, characterised in that N-substituted maleinimides are used.

4. A process as claimed in one of Claims 1 to 3, characterised in that bonding agents, in particular silanes, are used.

5. A process as claimed in one or more of Claims 1 to 4, characterised in that an addition product of glycidyl acrylate or methacrylate with the polycondensation product of 3.3'-dihydroxybenzidine and isophthalic acid dichloride or benzophenonedicarboxylic acid dichlorid is used.

6. A highly heat-resistant relief structure produced in accordance with one or more of Claims 1 to 5.

7. The use of the relief structure as claimed in Claim 6, as a resist having an intermediate protective function in the lithographic structuring of surfaces, in particular in dry etching processes.

8. The use of the relief structure as claimed in Claim 6, for the permanent coating or embossing of surfaces.

9. The use of the relief structure as claimed in Claim 6, as a protective and insulating material in electrical technology.